# DEMANDE DE BREVET EUROPEEN

(11) **EP 1 143 616 A1**
(43) Date de publication de la demande: **10.10.2001**
(21) Numéro de dépôt: 01400657.1
(22) Date de dépôt: 13.03.2001
(51) Int. Cl.: H03K 3/84

(54) **Générateur de nombres pseudo-aléatoires**

(30) Priorité: 17.03.2000 FR 0003458
(71) Demandeur: STMicroelectronics S.A., 94250 Gentilly (FR)
(72) Inventeur: Marinet, Fabrice, 75116 Paris (FR)
(74) Mandataire: Ballot, Paul

(57) **Abrégé**

L'invention concerne un générateur de nombres pseudo-aléatoires, caractérisé en ce qu'il comprend :
- un premier générateur (10) d'un signal en dents de scie à une première fréquence F1,
- un deuxième générateur (12) d'un signal impulsionnel à une deuxième fréquence F2,
- un circuit d'échantillonnage (14) échantillonnant le signal en dents de scie par le signal impulsionnel pour fournir un échantillon, et
- un circuit de codage (16) de l'amplitude de l'échantillon pour fournir des nombres binaires.

L'invention est applicable notamment aux circuits intégrés qui sont utilisés dans les cartes à puce avec ou sans contact.

## Description

L'invention concerne les générateurs de nombres pseudo-aléatoires sous la forme d'une suite temporelle de chiffres binaires 0 ou 1, ou sous la forme de codes binaires en parallèle.

Les générateurs de nombres pseudo-aléatoires sont bien connus dans le domaine de la cryptographie afin de réaliser un cryptage et un décryptage des messages et ainsi rendre impossible, sinon difficile, la compréhension de ces messages cryptés pour celui qui ne possède pas la clé de cryptage/décryptage.

De tels générateurs sont par exemple décrits dans la demande de brevet européen EP 0 878 907 et les demandes de brevets PCT WO 97/11423 et WO 97/43709.

Dans la demande de brevet EP 0 878 907, le générateur comprend principalement un premier oscillateur qui fournit un signal en dents de scie à une première fréquence et un deuxième oscillateur qui génère un train d'impulsions dont la fréquence est modulée par le signal en dents de scie du premier oscillateur.

Dans les générateurs des demandes de brevets WO 97/11423 et WO 97/43709, l'aléa est obtenu à partir d'un signal de bruit qui est échantillonné, puis codé.

Ces générateurs présentent l'inconvénient de mettre en oeuvre de nombreux éléments, tels qu'une source de bruit, un microprocesseur, des oscillateurs en anneau, et sont donc mal adaptés à certaines applications, telles que les circuits intégrés pour cartes à puce avec ou sans contact, dans lesquelles il est important de n'utiliser qu'un minimum d'éléments afin de limiter la consommation électrique.

L'invention a donc pour objet un générateur de nombres pseudo-aléatoires, caractérisé en ce qu'il comprend :
- un premier générateur d'un signal en dents de scie à une première fréquence F1,
- un deuxième générateur d'un signal impulsionnel à une deuxième fréquence F2,
- un circuit d'échantillonnage échantillonnant le signal en dents de scie par le signal impulsionnel pour fournir un échantillon, et
- un circuit de codage de l'amplitude de l'échantillon pour fournir des chiffres binaires en série ou en parallèle.

Le circuit de codage est un comparateur qui fournit un chiffre binaire 1 ou 0 selon que l'amplitude de l'échantillon est supérieure ou inférieure à un certain seuil.

Le circuit de codage est un convertisseur analogique/numérique qui fournit un nombre binaire parallèle représentatif de l'amplitude de l'échantillon.

D'autres caractéristiques et avantages de la présente invention apparaîtront à la lecture de la description suivante d'un exemple particulier de réalisation, ladite description étant faite en relation avec les dessins joints dans lesquels :
- la figure 1 est un schéma fonctionnel d'un générateur de nombres aléatoires selon l'invention,
- les figures 2A, 2B et 2C sont des diagrammes temporels de signaux,
- la figure 3 est un schéma d'un générateur de dents de scie,
- la figure 4 est un schéma d'un générateur d'un signal impulsionnel, et
- la figure 5 est un schéma de comparateur.

Le générateur de nombres pseudo-aléatoires selon l'invention comprend :
- un générateur 10 d'un signal en dents de scie à une fréquence F1 ;
- un générateur 12 d'un signal impulsionnel à une fréquence F2 qui est faible vis-à-vis de la fréquence F1, de l'ordre de cinq à dix fois plus faible ;
- un circuit d'échantillonnage 14 auquel est appliqué, d'une part, le signal en dents de scie à la fréquence F1 et, d'autre part, le signal impulsionnel à la fréquence F2 ; ce circuit d'échantillonnage fournit des échantillons du signal en dents de scie à la fréquence F2 du signal impulsionnel, et
- un circuit de codage 16 de l'amplitude de chaque échantillon qui fournit des nombres binaires soit sous la forme d'une série de chiffres binaires 1 ou 0, soit sous la forme de codes composés de N chiffres binaires 1 ou 0 en parallèle.

Le générateur de nombres pseudo-aléatoires selon l'invention peut comprendre aussi un générateur 22 de tensions de référence V⁺ et V⁻ qui sont appliquées au générateur de dents de scie 10 et au circuit de codage 16. Ces tensions de référence V⁺ et V⁻ définissent les valeurs supérieure et inférieure de la dent de scie ainsi que les valeurs extrêmes de l'intervalle de comparaison du circuit de codage 16.

Dans le cas où le générateur doit fournir une série de chiffres binaires, le circuit de codage 16 comprend un comparateur 18 qui compare l'amplitude de l'échantillon à une tension de référence médiane Vref = (V⁺ + V⁻)/2 du signal en dents de scie et qui fournit un signal représentatif du chiffre binaire 1 si l'amplitude de l'échantillon a une valeur supérieure ou égale à la tension médiane et un chiffre binaire 0 si l'amplitude de l'échantillon a une valeur inférieure à la tension médiane.

Au lieu de cette tension médiane, il est proposé d'utiliser la tension moyenne Vm de la tension en dents de scie, ce qui a pour avantage d'obtenir une série de chiffres binaires dans laquelle le nombre de chiffres 1 est sensiblement égal à celui des chiffres 0 au cours du temps.

Le signal fourni par le comparateur 18 est appliqué à un circuit bistable 20 qui bascule dans l'état défini par le signal de sortie du comparateur au moment défini par le signal impulsionnel du générateur 12.

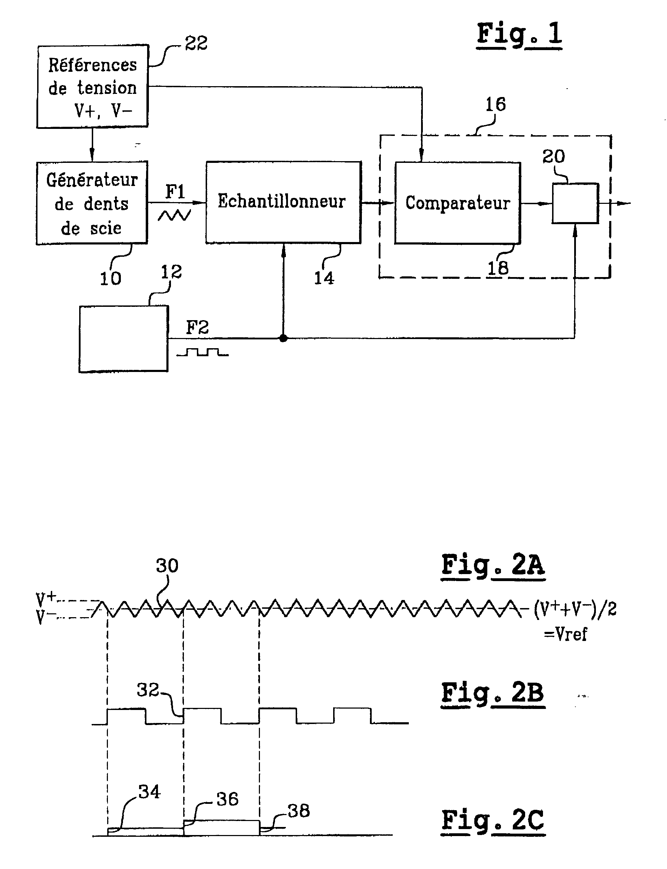

Dans le cas où le générateur doit fournir des codes composés de N chiffres binaires en parallèle, le comparateur 18 est remplacé par un convertisseur analogique/numérique de type classique. Ce convertisseur fournit ces codes sur N conducteurs de sortie qui sont connectés chacun à un circuit bistable, tel que celui référencé 20 sur la figure 1, dont le basculement s'effectue en synchronisme avec le signal impulsionnel fourni par le générateur 12.

Le fonctionnement du générateur du schéma de la figure 1 est le suivant :
- le générateur 10 fournit un signal 30 en dents de scie de la figure 2A dont l'amplitude varie entre les valeurs de référence V⁺ et V⁻. Ce signal est échantillonné par le signal impulsionnel 32 fourni par le générateur 12 dans le circuit d'échantillonnage 14 qui fournit des échantillons 34, 36 et 38 dont les amplitudes sont respectivement inférieure, supérieure et inférieure à la tension médiane (V⁺ + V⁻)/2. Il en résulte que le comparateur 18 fournit respectivement et successivement des signaux représentant les chiffres binaires 0, 1 et 0.

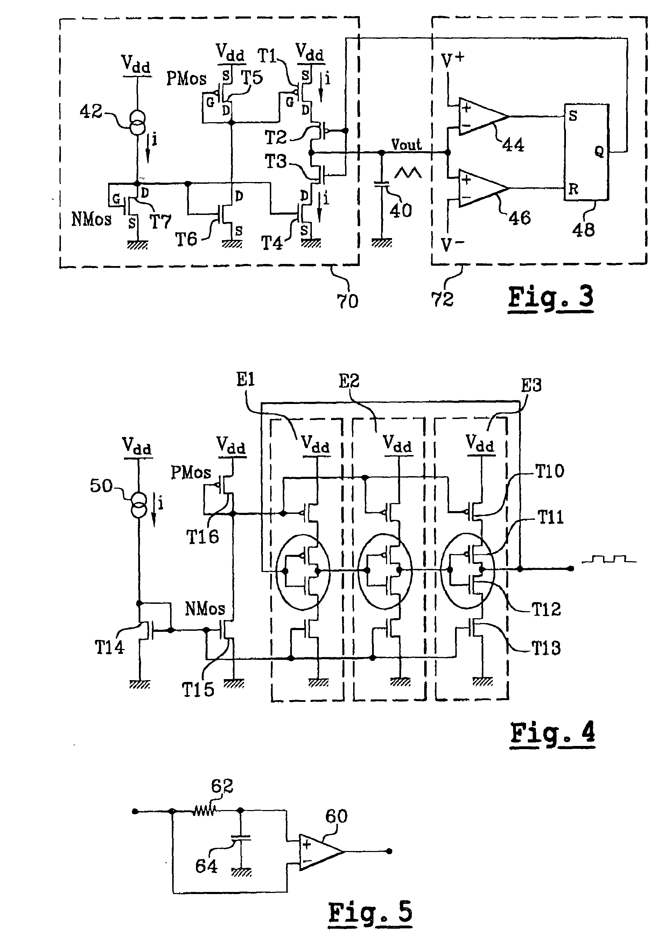

Le générateur de dents de scie 10 peut être réalisé de différentes manières et, notamment, suivant le schéma de la figure 3. Il comprend un condensateur 40 qui est chargé et déchargé linéairement par un courant "i" fourni par un générateur de courant 42. Ce courant i est commuté dans un sens charge ou décharge du condensateur 40 par un dispositif de commutation 70 qui est commandé par un dispositif de commande 72.

Le dispositif de commande 72 comprend deux comparateurs 44 et 46 et une bascule 48. La borne d'entrée positive du comparateur 44 reçoit la tension de référence V⁺ tandis que la borne d'entrée négative est connectée à la borne positive du condensateur 40 dont l'autre borne est connectée à la masse. La borne positive du condensateur 40 est aussi connectée à la borne d'entrée positive du comparateur 46 dont la borne d'entrée négative reçoit la tension de référence V⁻.

Le comparateur 44 fournit un signal de mise à l'état 1 de la bascule 48 (borne S) lorsque la tension de charge Vout du condensateur 40 est supérieure ou égale à V⁺. De manière symétrique, le comparateur 46 fournit un signal de mise à l'état 0 de la bascule 48 (borne R) lorsque la tension de charge Vout du condensateur 40 est inférieure ou égale à V⁻.

La borne de sortie Q de la bascule 48 est connectée au dispositif de commutation 70 qui comprend les transistors T1 à T7 et le générateur de courant 42. Plus précisément, la borne Q est connectée aux grilles du transistor P-MOS référencé T2 et du transistor N-MOS référencé T3.

Le courant i, fourni par le générateur de courant 42, alimente les transistors T2 et T3 par l'intermédiaire de "miroirs de courant" comprenant des transistors T5 et T1 de type P-MOS pour le transistor T2 et des transistors T4, T6 et T7 de type N-MOS pour le transistor T3. Dans ces miroirs de courant, les transistors T5 et T7 ont leur grille qui est connectée à leur drain pour réaliser une diode.

Le générateur 42 de courant i est connecté directement au potentiel d'alimentation Vdd et à la masse par l'intermédiaire du transistor T7. Le drain D et la grille G du transistor T7 sont connectés à la grille G des transistors T4 et T6, ce qui définit la valeur du courant circulant dans ces deux transistors T4 et T6 dont la source S est connectée à la masse.

Le drain et la grille G du transistor T5 sont connectés à la grille G du transistor T1, ce qui définit la valeur du courant circulant dans le transistor T1. Les sources des transistors T1 et T5 sont connectées directement au potentiel d'alimentation Vdd.

Les transistors de commutation T2 et T3 ont leur source S qui est connectée respectivement au drain D des transistors T1 et T4 tandis que leur drain constitue le point commun qui est connecté à la borne positive du condensateur 40.

Le fonctionnement du générateur de dents de scie de la figure 3 est le suivant.

Le condensateur 40 est chargé par le courant i circulant dans les transistors T1 et T2 et déchargé par le courant i circulant dans les transistors T3 et T4.

Pendant la charge, le transistor T2 conduit tandis que le transistor T3 est bloqué. Dès que la tension de charge Vout du condensateur 40 atteint V⁺, le comparateur 44 et la bascule 48 changent d'état, ce qui bloque T2 et débloque T3. Le condensateur 40 est alors déchargé par un courant i de sorte que lorsque la tension de charge Vout atteint la valeur inférieure V⁻, le comparateur 46 et le circuit bistable 48 changent d'état et ce dernier fournit un signal de déblocage du transistor T2 et de blocage du transistor T3.

L'utilisation d'un générateur de courant 42 associé à des miroirs de courant permet d'obtenir des courants de charge et de décharge qui sont identiques.

Le générateur du signal impulsionnel 12 peut être réalisé de différentes manières et, notamment, suivant le schéma de la figure 4. Il comprend un oscillateur en anneau à un nombre impair d'étages, par exemple trois référencés E1, E2 et E3. Chaque étage E1, E2 ou E3 comprend quatre transistors T10 à T13 en série, les transistors T10 et T11 étant du type P-MOS tandis que les transistors T12 et T13 sont du type N-MOS.

Plus précisément, chaque étage comprend un circuit inverseur comprenant les transistors T11 et T12, chaque transistor T11 ou T12 étant alimenté, lorsqu'il conduit, par un transistor T10 ou T13 qui fait partie d'un "miroir de courant". Le potentiel de la grille du transistor T10 est fixé par un transistor T16 du type P-MOS qui est monté en diode par une connexion grille-drain. De même, le potentiel de la grille du transistor T13 est fixé par un transistor T14 du type N-MOS qui est monté en diode par une connexion grille-drain. Enfin, un transistor T15 du type N-MOS a sa grille qui est connectée au point commun drain-grille du transistor T14, ce qui fixe son potentiel et donc le courant circulant dans le transistor T16.

La valeur du courant i est fixée par un générateur de courant 50 dont une borne est connectée à la tension d'alimentation Vdd et dont l'autre borne est connectée au drain du transistor T14 dont la source est connectée au potentiel de masse.

Dans chaque étage, la source du transistor T13 est connectée au potentiel de masse tandis que la source du transistor T10 est connectée à la tension d'alimentation Vdd.

Le drain de chaque transistor T10 ou T13 est connecté respectivement à la source du transistor T11 ou T12, les drains de ces transistors T11 et T12 étant connectés ensemble pour constituer la borne de sortie de l'étage considéré. La borne de sortie de l'étage E1 et de l'étage E2 est connectée respectivement aux grilles des transistors T11 et T12 de l'étage suivant E2 ou E3. La borne de sortie de l'étage E3 est, quant à elle, connectée aux grilles des transistors T11 et T12 de l'étage E1.

Par ce bouclage de sortie de l'étage E3 vers l'entrée de l'étage E1, on obtient un oscillateur en anneau dont le fonctionnement est bien connu.

Le comparateur 18 est par exemple du type selon le schéma de la figure 5 et comprend un comparateur 60 dont la borne d'entrée négative est connectée directement à la borne de sortie du circuit d'échantillonnage 14. La borne d'entrée positive du comparateur 60 est également connectée à la borne de sortie du circuit d'échantillonnage par l'intermédiaire d'un circuit RC comprenant une résistance 62 et un condensateur 64.

Dans le générateur de nombres pseudo-aléatoires selon l'invention, l'aléa provient du fait que les signaux de fréquences F1 et F2 sont asynchrones. Il est pseudo-aléatoire car il existe une corrélation entre deux échantillons consécutifs. Cette corrélation sera d'autant plus faible que le rapport F1/F2 est grand.

## Revendications

1. Générateur de nombres pseudo-aléatoires, **caractérisé en ce qu'**il comprend :
- un premier générateur (10) d'un signal en dents de scie à une première fréquence F1 fixe,
- un deuxième générateur (12) d'un signal impulsionnel à une deuxième fréquence F2 fixe,
- un circuit d'échantillonnage (14) échantillonnant le signal en dents de scie par le signal impulsionnel pour fournir un échantillon, et
- un circuit de codage (16) de l'amplitude de l'échantillon pour fournir des chiffres binaires en série ou en parallèle et en synchronisme avec le signal impulsionnel fourni par ledit deuxième générateur.

2. Générateur selon la revendication 1, **caractérisé en ce que** le circuit de codage (16) est un comparateur (60) qui fournit un signal représentatif d'un chiffre binaire 1 ou 0 selon que l'amplitude de l'échantillon appliquée à une borne d'entrée est supérieure ou inférieure à une valeur de référence (Vref) appliquée à l'autre borne d'entrée.

3. Générateur selon la revendication 2, **caractérisé en ce que** la valeur de référence (Vref) est égale à la valeur médiane d'excursion des dents de scie du signal fourni par le premier générateur (10).

4. Générateur selon la revendication 2, **caractérisé en ce que** la valeur de référence (Vref) est égale à une valeur moyenne (Vm) des amplitudes des échantillons.

5. Générateur selon la revendication 4, **caractérisé en ce que** la valeur moyenne (Vm) est obtenue par un circuit RC (62, 64) auquel sont appliqués les signaux échantillonnés.

6. Générateur selon la revendication 1, **caractérisé en ce que** le circuit de codage est un convertisseur analogique/numérique qui fournit un code binaire à N chiffres en parallèle représentatif de l'amplitude dudit échantillon.

7. Générateur selon l'une quelconque des revendications précédentes 1 à 6, **caractérisé en ce que** le premier générateur (10) d'un signal en dents de scie à la fréquence F1 comprend :
- un condensateur 40,
- des moyens de commutation du courant (i) de charge et de décharge (70) dudit condensateur (40), et
- des moyens de commande de la commutation (72) dudit courant (i) pour obtenir une succession de charges et de décharges dudit condensateur (40).

8. Générateur selon la revendication 7, **caractérisé en ce que** les moyens de commande de la commutation (72) comprennent :
- deux comparateurs (44, 46) pour comparer chacun la tension de charge (Vout) dudit condensateur (40) à une valeur de référence (V⁺, V⁻) et fournir un signal lorsque la tension de charge (Vout) atteint la valeur de référence (V⁺ ou V⁻), et
- une bascule (48) pour mémoriser le signal fourni successivement par chaque comparateur.

9. Générateur selon la revendication 7 ou 8, **caractérisé en ce que** les moyens de commutation 70 du courant (i) de charge et de décharge du condensateur (40) comprennent :
- un générateur de courant (42) pour fournir un courant constant (i) ;
- des miroirs de courant (T1, T4 à T7) pour reproduire le courant (i) de manière à permettre l'alimentation du condensateur (40) selon deux sens de circulation, et
- un commutateur (T2, T3) commandé par les moyens de commande de la commutation (72) pour sélectionner le sens de circulation du courant dans ledit condensateur (40).

10. Générateur selon l'une quelconque des revendications précédentes 1 à 9, **caractérisé en ce que** le deuxième générateur (12) d'un signal impulsionnel à une deuxième fréquence F2 est un oscillateur en anneau à un nombre impair d'étages (E1, E2, E3) **caractérisé en ce que** :
- chaque étage (E1, E2 ou E3) comprend un circuit inverseur à deux transistors (T11, T12), chaque transistor (T11 ou T12) étant alimenté par un transistor (T10 ou T13) dont le potentiel de grille est fixé par un transistor (T16 ou T14) monté en diode et alimenté par un courant constant (i) fourni par un générateur de courant (50).
